# EUROPEAN PATENT APPLICATION

(11) **EP 4 653 885 A1**
(43) Date of publication of application: **26.11.2025**
(21) Application number: 25715452.6
(22) Date of filing: 06.03.2025
(51) Int. Cl.: G01R 31/28, G01R 1/04, G01R 1/067

(54) **HYBRID TEST SOCKET**

(30) Priority: 04.04.2024 KR 20240046115
(71) Applicant: Hicon Co., Ltd., Seongnam-si, Gyeonggi-do 13211 (KR); Hwang, Dong Weon, Seongnam-si, Gyeonggi-do 13544 (KR); Hwang, Jae Baek, Seongnam-si, Gyeonggi-do 13544 (KR)
(72) Inventor: HWANG, Dong Weon, Seongnam-si Gyeonggi-do 13544 (KR); HWANG, Jae Baek, Seongnam-si Gyeonggi-do 13544 (KR); RHEE, Seung Woo, Seongnam-si Gyeonggi-do 13187 (KR)
(74) Representative: BCKIP Part mbB
(86) International application number: PCT/KR2025/002975
(87) International publication number: WO 2025/211593

(57) **Abstract**

Disclosed is a hybrid test socket including: a body having a hole passing through a first surface facing a terminal of a semiconductor device and a second surface facing a pad of a test device; a contact inserted into the hole to thus allow one end in contact with the terminal of the semiconductor device and the other end in contact with the pad of the test device, thereby having elasticity in a pressing direction; and a first member bonded to one end of the contact.

## Description

### [Technical Field]

The disclosure relates to a hybrid test socket including a socket body made of an elastic insulator and a contact pin having elasticity.

### [Background Art]

In general, a semiconductor integrated circuit (IC) of a ball grid array (BGA) or a land grid array (LGA) type is finally subjected to characteristic measurement or defect inspection through various electrical tests by a test device. Here, a test socket may be used to electrically connect a circuit pattern of a test printed circuit board installed on the test device to a contact ball of a BGA-type terminal (lead) or a land of an LGA-type semiconductor IC terminal (lead).

A contact used in the test socket is required to have sufficient pressing force to ensure reliable contact with the IC lead. Therefore, the contact is required to have sufficient elastic contact force within an appropriate range. Various types of contacts are available to meet these conditions.

Meanwhile, a number of spring contacts may be installed in a housing according to a predetermined rule in the test socket. Recently, various semiconductor devices have been developed, and customer demands for spring contacts of various lengths are increasing. However, conventional pogo pin-type spring contacts often fail to meet customer performance requirements.

For example, when manufacturing the conventional pogo pin-type spring contact to be longer to meet the customer requirement, a length of a contact pin included in the spring contact is required to be increased. Simultaneously, when designing the test socket, a depth of a pin hole into which the spring contact is inserted is required to be processed to a diameter that accommodates a width of a tip of the contact pin in consideration of the length of the contact pin.

As the contact pin of the spring contact is gradually becoming finer for faster data processing and lower power consumption, it may be difficult to process a long pin hole having a diameter that accommodates the width of the tip of the contact pin. In addition, even if it is possible to process the long pin hole having a relatively small diameter that accommodates the width of the tip of the contact pin, processing costs may be high and quality assurance may be difficult.

That is, the conventional spring contacts have difficulty meeting the requirements of customers who require the spring contacts of various lengths.

Meanwhile, as another conventional technology, there is a rubber-type socket, and this rubber socket may include an insulating body having elasticity by solidifying insulating silicone and a conductive silicone portion vertically penetrating through the insulating body to correspond to a terminal of the device.

In this rubber-type socket, when a silicone mixture including the insulating silicone and conductive powder in a predetermined ratio is placed in a mold and a strong magnetic field is formed at a position where the conductive silicone portion is to be formed, the conductive powder in the silicone mixture may gather at the position where the magnetic field is to be formed, and a molten silicone mixture may be finally solidified, thereby forming the conductive silicone portions arranged in a predetermined manner in the insulating body.

This rubber-type socket may have a slower elastic response speed compared to the pin-type contact (spring contact) and may lose elasticity during repeated testing, which may significantly reduce service lifespan, resulting in a reduced number of uses and increased costs due to frequent replacement. In addition, this rubber-type socket is difficult to use for long-term testing due to its characteristic that elasticity durability decreases over time, which results in the elastic rebound force becoming zero or significantly reduced during continuous compression tests for extended periods (one week or more), thereby causing a short circuit.

Furthermore, the rubber-type socket may have an elastic property greatly affected by temperature and resistance uniformity that is reduced due to mixed insulating silicone or mixed elastomer.

### [Disclosure]

### [Technical Problem]

The disclosure has been invented in consideration of the above problems, and an object of the disclosure is to provide a hybrid test socket combining advantages of pogo pin-type and rubber-type sockets.

Another object of the disclosure is to provide a test socket suitable for testing a semiconductor device having a high-speed signal. Another object of the disclosure is to provide a test socket having improved noise shielding performance between adjacent contact pins and improved coaxial alignment performance of contact pins.

Another object of the disclosure is to provide a test socket (having high temperature stability) that may minimize an influence of temperature changes.

Another object of the disclosure is to provide a hybrid test socket equipped with various types of contact pins to suit a customer performance requirement.

### [Technical Solution]

According to an embodiment, provided is a hybrid test socket including: a body having a hole passing through a first surface facing a terminal of a semiconductor device and a second surface facing a pad of a test device; a contact inserted into the hole to thus allow one end in contact with the terminal of the semiconductor device and the other end in contact with the pad of the test device, thereby having elasticity in a pressing direction; and a first member bonded to one end of the contact.

The first member may be disposed between an inner surface of the hole adjacent to the first surface and a periphery of one end of the contact.

The body may include bases forming an exterior of the test socket, and an elastic insulator filling an interior of the bases and then cured to provide the elasticity, and the hole passes through the elastic insulator.

The contact may include a pair of contact pins, and a spring coupled between the pair of contact pins to provide the elasticity.

The pair of contact pins may have the same shape and be coupled to each other in a direction in which the contact pins intersect each other.

The contact pin may include a body part having predetermined width and thickness, a head part disposed at one end of the body part and in contact with a test target, and a leg part extending in a direction opposite to the head part along a length direction of the body part.

The head part may be formed by rolling a plate-shaped strip integrally formed with the body part.

The head part may have a plurality of tips disposed at an upper end.

The first member may be disposed between at least a portion of a peripheral surface of the head part and the inner surface of the hole.

The second surface may include a step hole forming a step toward the first surface.

The step hole may have a diameter larger than a diameter of the hole.

The first member may be bonded to a surface of one end of the contact, rolled into a space between the periphery of one end of the contact and the hole, and then cured.

The contact may include a contact pin, and an elastic member including conductive particles filling a space between the contact pin and the hole.

The contact pin may be formed by rolling a plate-shaped strip.

The conductive particles may be aligned by simultaneously applying magnetic force to the elastic member while performing the bonding of the first member.

Each feature of the embodiments described above may be implemented in combination with other embodiments as long as the feature does not contradict or exclude other embodiments.

### [Advantageous effect]

According to the various embodiments of the disclosure, the upper shrinkage of the socket body made of the elastic insulator may be easily controlled.

In addition, the easier positional alignment of the contact pin contact portions provided inside the socket body may improve the coaxial alignment of the contact pins.

In addition, the improved insulation between the fine pitches may reduce the noise occurring when testing the high-speed signal semiconductor device.

The advantages of the disclosure are not limited to those described above, and other advantages not mentioned are clearly recognizable to those skilled in the art from the following description.

### [Description of Drawings]

FIG. 1 is a view showing a hybrid test socket, which is an embodiment of the disclosure.
FIG. 2 is a view showing a spring contact pin in FIG. 1.
FIG. 3 is an exploded perspective view of FIG. 2.
FIGS. 4 to 8 are views showing the contact pin in FIG. 2.
FIGS. 9A to 9D are views showing a manufacturing process of the hybrid test socket in FIG. 1.
FIG. 10 is a view showing a hybrid test socket, which is another embodiment of the disclosure.
FIG. 11 is a view showing a contact pin in FIG. 10.

### [Best Mode]

Hereinafter, specific embodiments of the disclosure are described with reference to the accompanying drawings. A detailed description below is provided to facilitate a comprehensive understanding of a method, an apparatus and/or a system, described in the specification. However, the embodiments are only described by way of examples and the disclosure is not limited thereto.

In describing the embodiments of the disclosure, omitted is a detailed description of a case where it is decided that the detailed description of the known functions or configurations related to the disclosure may unnecessarily obscure the gist of the disclosure. In addition, terms described below are those defined in consideration of functions in the disclosure, and may be construed in different ways by the intentions of users or operators, or practices. Therefore, the terms should be defined on the basis of the contents throughout the specification.

Terms used in the detailed description are merely to describe the embodiments of the disclosure, and should not be construed to be restrictive. A term of a single number may include its plural number unless explicitly indicated otherwise.

It should be understood that terms "include", "have", or the like, used in the specification specify certain features, numerals, steps, operations, elements, or portions or combinations thereof, and it should not be construed to exclude the presence or possibility of one or more other features, numbers, steps, operations, elements, or portions or combinations thereof other than those described.

In addition, terms 'first', 'second', A, B, (a), (b), and the like, may be used in describing components of an embodiment of the disclosure. These terms are only used to distinguish any components from other components, and the essences, sequences, order, or the like of the corresponding components are not limited by these terms.

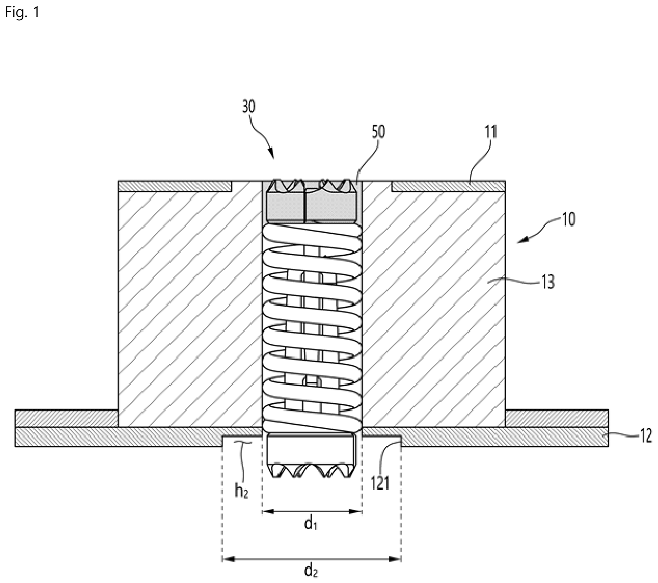

FIG. 1 is a view showing a hybrid test socket, which is an embodiment of the disclosure.

Hereinafter, the hybrid test socket, which is an embodiment of the disclosure, is described with reference to FIG. 1.

The hybrid test socket may include a body 10 and a contact 3.

The body 10 may be made of a material having elasticity due to pressing of a semiconductor device, and the contact 30 may have a physical configuration having elasticity (e.g., a spring) or may be made of a material having elasticity (e.g., silicon powder mixed with conductive particles).

In more detail, the body 10 may have a hole passing through a first surface 11 facing a terminal of the semiconductor device and a second surface 12 facing a pad of a test device. A diameter d1 of the hole may be formed to be equal to or larger than the maximum diameter of the contact 30 and the contact 30 may thus be inserted into the hole.

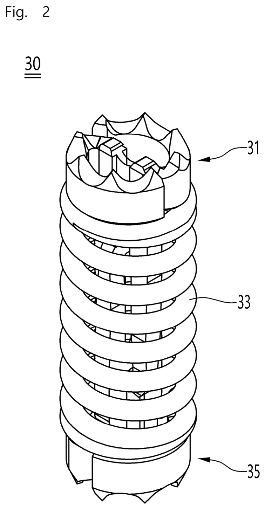

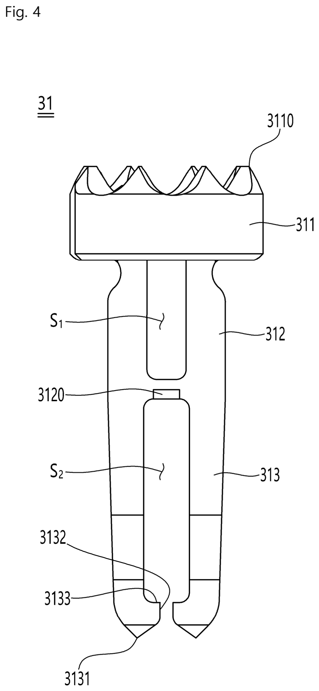

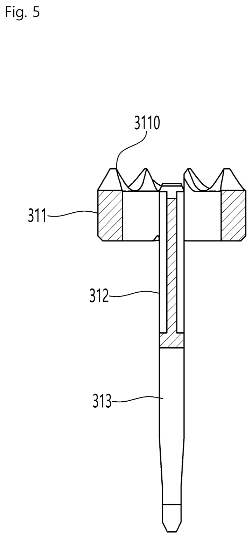

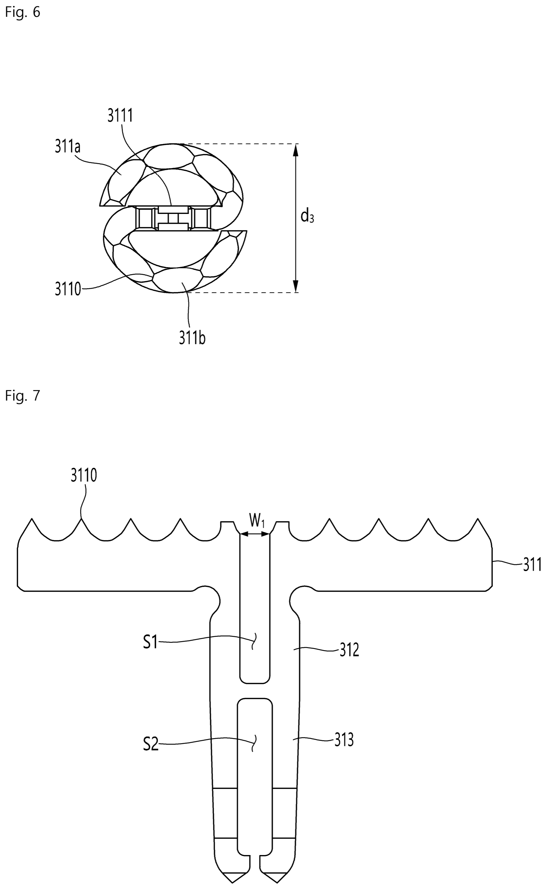

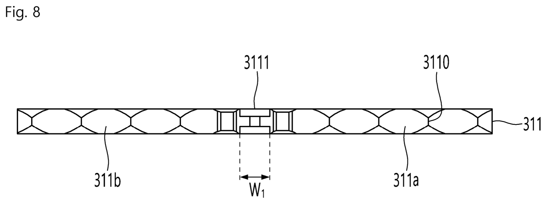

That is, the contact 30 may be inserted into the hole to thus allow one end to be in contact with the terminal of the semiconductor device and the other end to be in contact with the pad of the test device, thereby having elasticity in a pressing direction. A specific configuration of the contact 30 according to an embodiment of the disclosure is described below in more detail with reference to FIGS. 2 to 8.

Meanwhile, the body 10 may include bases 11 and 12 forming an exterior of the test socket, and an elastic insulator 13 filling an interior of the bases 11 and 12 and then cured to provide the elasticity.

The bases 11 and 12 may be formed using the first surface 11 and the second surface 12, and the hole may pass through the first surface 11 and the second surface 12 to thus pass through the elastic insulator filling the interior of the bases 11 and 12.

Meanwhile, a first member 50 may be bonded to one end of the contact 30. One end of the contact 30 may indicate a contact end of the contact 30 disposed to be adjacent to the first surface 11 in contact with the terminal of the semiconductor device while the contact 30 is inserted into the hole.

The first member 50 may be disposed between an inner surface of the hole adjacent to the first surface 11 and a periphery of one end of the contact 30. The first member 50 may be made of a flexible material, bonded while disposed on a surface of one end of the contact 30, rolled into a space between the periphery of one end of the contact 30 and the hole, and then cured, thereby being disposed between the inner surface of the hole adjacent to the first surface 11 and the periphery of one end of the contact 30. Accordingly, the first member 50 may be made of a material such as a silicone-based material whose property changes due to heat.

Due to the placement of the first member 50, an upper shrinkage of the socket body 10 including the elastic insulator 13 may be easily controlled.

If, unlike this embodiment, the socket body 10 is made of a material having no elasticity such as a general spring contact pin-type socket, shrinkage of the socket body does not occur. Accordingly, if the first member 50 is disposed, the first member 50 may act as a factor that inhibits contractile force of the spring contact pin. However, this embodiment discloses the hybrid test socket combining advantages of the general spring contact pin-type socket (poco pin-type socket) and a silicone rubber-type socket as described above, which has durability increased by controlling the upper shrinkage of the socket body 10 using the first member 50.

In addition, a coaxial alignment of the contact 30 inside the body 10 including an elastic material may be improved using the first member 50, thereby improving the positional alignment of the contact portion of the contact 30.

In addition, the first member 50 may be made of the silicon-based material to thus improve insulation between fine pitches, thereby reducing noise when testing a high-speed signal semiconductor device.

The first member 50 may be appropriately selected to suit a customer need between shore hardness 20A and 80A. If the hardness of the first member 50 is out of the above range, it may be difficult to achieve the aforementioned advantages.

For example, if the hardness of the first member 50 is higher than the aforementioned range, the first member 50 may act as a factor that inhibits the elasticity of the contact 30, thus requiring a greater load during the test. In this case, the test socket may fail to meet a load-related performance condition requested by a customer or have reduced durability.

Meanwhile, the second surface 12 may include a step hole h2. The step hole h2 may form a step in a direction from the second surface 12 toward the first surface 11. In a shape of the step hole h2, a diameter d2 of the step hole h2 may be larger than the diameter d1 of the hole.

The step hole h2 may increase the durability of the hybrid test socket, which is an embodiment of the disclosure, by distributing the load of the test socket repeatedly pressed between the terminal of the semiconductor device and the pad of the test device. If the step hole h2, such as in this embodiment, is not provided, the body is required to absorb all the load around the contact, which may reduce the durability.

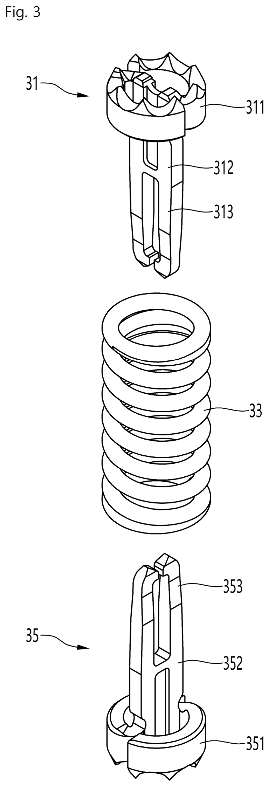

FIG. 2 is a view showing a spring contact pin in FIG. 1; FIG. 3 is an exploded perspective view of FIG. 2; and FIGS. 4 to 8 are views showing the contact pin in FIG. 2.

Hereinafter, referring to FIGS. 1 to 8, the description describes the hybrid test socket, which is an embodiment of the disclosure, and the contact applied to the hybrid test socket.

The contact 30 in this embodiment may include a configuration of the spring contact pin. That is, the contact 30 may include two contact pins 31 and 35 and a spring 33 that provides physical elasticity to the contact 30.

In more detail, the contact 30 may include the pair of contact pins 31 and 35 and the spring 33, and the spring 33 may be coupled between the pair of the contact pins 31 and 35 to provide the elasticity to the contact 30.

The spring 33 may be a coil-type compression spring having a predetermined length along a length direction of the contact 30, and disposed between the first and second contact pins 31 and 35 of the contact 30. Accordingly, when the first contact pin 31 and the second contact pin 35 are compressed in the length direction, a restoring force may be provided to return each of the contact pins 31 and 35 to a position before being compressed based on the spring 33.

In this embodiment, the pair of contact pins 31 and 35 may have the same shape and be coupled to each other in a direction in which the contact pins 31 and 35 intersect each other. In addition, the pair of contact pins 31 and 35 may have different shapes and be coupled to each other while having the spring therebetween.

Hereinafter, the pair of contact pins are referred to as the first contact pin 31 and the second contact pin 35, and in this embodiment, the pair of contact pins 31 and 35 have the same shape, and the configuration of the contact pin is described based on the first contact pin 31.

The contact pin 31 may include a body part 312, a head part 311, and a leg part 313.

The body part 312 may have a space S1 recessed at the center of each of both surfaces and having predetermined width and length in the length direction, and a catch (not shown) having a step may be formed at a lower end of the space S1, and an upper end of the space S1 may extend to an upper end of the head part 311. The catch (not shown) indicates a configuration in which an end of a leg part 353 of the second contact pin 35 is caught when the second contact pin 35 is coupled to the first contact pin 31 in the intersecting direction.

The head part 311 may be formed as a plate-shaped strip having an upper tip 3110 formed along an upper end, and having the same length on right and left sides relative to the center of the body part 312 from an upper end of the body part 312. The plate-shaped strip may include a first strip section 311a and a second strip section 311b, having the same distance on right and left sides from a center 3111 of the body part 312.

That is, the head part 311 may have a cylindrical shape having an overall diameter d3 by rolling each of the first strip section 311a and the second strip section 311b into a semicircular arc shape based on the center 3111. In addition, a width W1 of the center 3111, which serves as a reference for rolling each strip, may preferably correspond to a width of the space S1. The reason is that if the width W1 of the center 3111 is smaller or larger than the width of the space S1, a defect rate may increase when stamping the contact pin in a sheet metal form.

Meanwhile, the head part 311 may have a cylindrical crown shape by the tip 3110. In this shape or configuration of the head part 311, a ball portion of the BGA may be stably grounded to press the test socket, thereby improving test accuracy.

Meanwhile, the pair of leg parts 313, symmetrically extending from the body part 312, may be provided, and a predetermined space S2 may be disposed between the pair of leg parts and guide each leg part when the first contact pin 31 and the second contact pin 35 are coupled to each other in the intersecting direction.

In addition, when assembling the contact 30, an inclined surface 3120 may be disposed at a portion where the pair of leg parts 313 extend from the body part 312 to facilitate the assembly in the direction in which the second contact pin 35 intersects the first contact pin 31.

In more detail, the leg part 313 may have a catch member formed at an end, and the catch member may include a corner part 3131 disposed on the same plane as the tip 3110 and making electrical contact with the terminals when the contact 30 is compressed in the pressing direction, a guide surface 3132 extending from the corner part 3131 to form a predetermined inclination and face each other, and an inflection end 3133 forming a step toward the outside of the space S2 from the guide surface 3132.

In this structure, the guide surface 3132 may come into contact with and be coupled to the inclined surface 3120 during assembly between the respective contact pins, thus facilitating the assembly between the pair of contact pins, and the inflection end 3133 may be caught by the catch (not shown) during the assembly between the respective contact pins, thereby preventing the pair of contact pins from being unintentionally separated after the coupling.

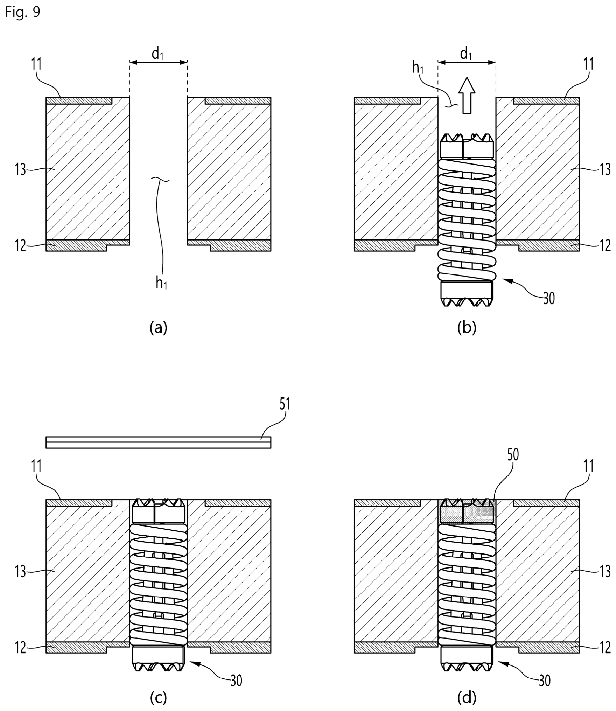

FIGS. 9A to 9D are views showing a manufacturing process of the hybrid test socket in FIG. 1.

Hereinafter, referring to FIGS. 9A to 9D, the description describes the manufacturing process of the hybrid test socket, which is an embodiment of the disclosure.

Referring to FIG. 9A, the body of the test socket may have a hole h1 disposed in the cured elastic insulator 13 by performing a jig operation or laser processing. The hole disposed therein may have the diameter d1 that is equal to or larger than the diameter d3 of the head part included in the contact pin.

Referring to FIGS. 9B and 9C, after the contact 30 is inserted into the hole h1, a film 51 on which the first member 50 is stacked may be bonded to an upper portion of the first surface 11, and the first member 50 may thus be disposed between the inner surface of the hole adjacent to the first surface 11 and the periphery of one end of the contact 30.

In more detail, the film 51 may be heat-pressed to allow the first member 50 to be effectively rolled into the space between the inner surface of the hole adjacent to the first surface 11 and the periphery of one end of the contact 30. The first member 50 heat-pressed in this way may be disposed between at least a portion of a peripheral surface of the head part 311 and the inner surface of the hole h1. In addition, the tip 3110 may penetrate through the first member 50 to be exposed to the outside due to its shape when the first member 50 is pressed.

In this state, the first member 50 may be cured, thus completing the manufacturing process of the hybrid test socket, which is an embodiment of the disclosure, as shown in FIG. 9D.

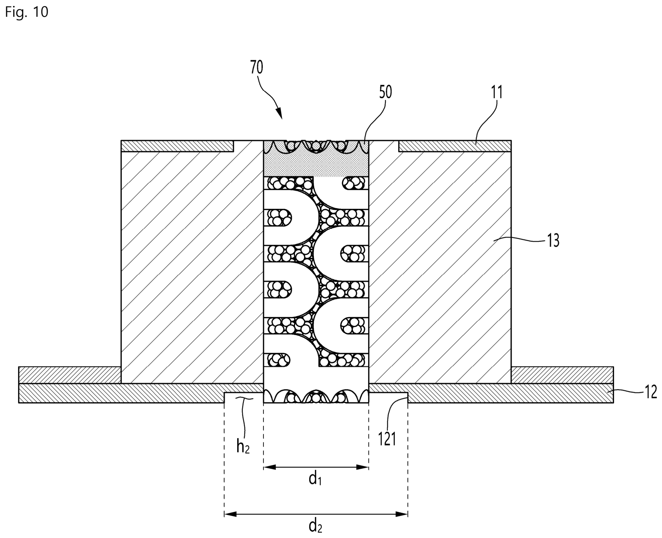

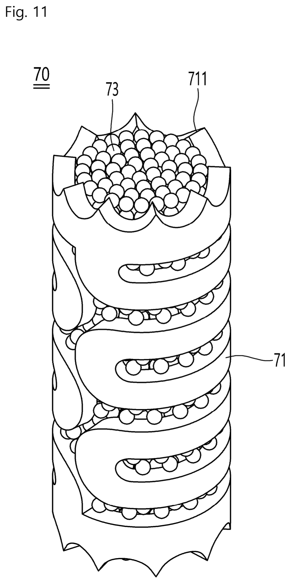

FIG. 10 is a view showing a hybrid test socket, which is another embodiment of the disclosure; and FIG. 11 is a view showing a contact pin in FIG. 10.

Hereinafter, referring to FIGS. 10 and 11, the description describes the hybrid test socket using the contact having a different form from that shown in FIGS. 1 to 9, and focuses mainly on its differences from the embodiment described above.

A contact 70 applied to the hybrid test socket in this embodiment may be formed by rolling a contact pin 71 stamped in the sheet metal form, thereby forming the contact pin 71 in a shape similar to the coil-type compression spring, and an end of the contact pin 71 may be formed in the crown shape by a plurality of tips 711.

In this shape or structure, the contact pin 71 of the contact 70 in this embodiment may perform a function of the spring applied to the spring contact pin.

In addition, as the plate is rolled and formed, the contact 70 may have a space formed therein, and the space may be filled with an elastic member 73 including the conductive particles. In more detail, the elastic member 73 may be formed by silicon including metal conductive particles filling a space between the contact pin 71 and the hole and then curing the same.

Meanwhile, the first member 50 may be disposed between an end of the contact 70 including the tip 711 and the hole. For this structure, the first member 50 may be heat-pressed on the first surface 11 as described above.

However, the contact 70 in this embodiment may be filled with the elastic member 73 including the conductive particles, it is thus necessary to align the conductive particles using magnetism in order to improve an electrical contact ability of the contact 70.

Therefore, in this embodiment, the conductive particles may be aligned by simultaneously applying magnetic force to the elastic member 73 while performing the bonding of the first member 50 in order to simplify the process and to easily roll the first member 50 into a space between the end of the contact 70 and the hole. That is, the process of heat-pressing the film and the process of applying the magnetic force to the conductive particles may be performed simultaneously.

Although the various embodiments of the disclosure have been specifically described above, those skilled in the art to which the disclosure pertains may appreciate that the embodiments described above may be changed in various ways without departing from the scope of the disclosure. Accordingly, the scope of the disclosure is not construed as being limited to the described embodiments, and defined by the appended claims as well as equivalents thereto.

## Claims

1. A hybrid test socket comprising:
a body having a hole passing through a first surface facing a terminal of a semiconductor device and a second surface facing a pad of a test device;
a contact inserted into the hole to thus allow one end in contact with the terminal of the semiconductor device and the other end in contact with the pad of the test device, thereby having elasticity in a pressing direction; and
a first member bonded to one end of the contact.

2. The hybrid test socket of claim 1, wherein the first member is disposed between an inner surface of the hole adjacent to the first surface and a periphery of one end of the contact.

3. The hybrid test socket of claim 2, wherein the body includes
bases forming an exterior of the test socket, and
an elastic insulator filling an interior of the bases and then cured to provide the elasticity, and
the hole passes through the elastic insulator.

4. The hybrid test socket of claim 3, wherein the contact includes
a pair of contact pins, and
a spring coupled between the pair of contact pins to provide the elasticity.

5. The hybrid test socket of claim 4, wherein the pair of contact pins have the same shape and are coupled to each other in a direction in which the contact pins intersect each other.

6. The hybrid test socket of claim 5, wherein the contact pin includes
a body part having predetermined width and thickness,
a head part disposed at one end of the body part and in contact with a test target, and
a leg part extending in a direction opposite to the head part along a length direction of the body part.

7. The hybrid test socket of claim 6, wherein the head part is formed by rolling a plate-shaped strip integrally formed with the body part.

8. The hybrid test socket of claim 7, wherein the head part has a plurality of tips disposed at an upper end.

9. The hybrid test socket of claim 8, wherein the first member is disposed between at least a portion of a peripheral surface of the head part and the inner surface of the hole.

10. The hybrid test socket of claim 3, wherein the second surface includes a step hole forming a step toward the first surface.

11. The hybrid test socket of claim 10, wherein the step hole has a diameter larger than a diameter of the hole.

12. The hybrid test socket of claim 2, wherein the first member is bonded to a surface of one end of the contact, rolled into a space between the periphery of one end of the contact and the hole, and then cured.

13. The hybrid test socket of claim 3, wherein the contact includes
a contact pin, and
an elastic member including conductive particles filling a space between the contact pin and the hole.

14. The hybrid test socket of claim 13, wherein the contact pin is formed by rolling a plate-shaped strip.

15. The hybrid test socket of claim 13, wherein the conductive particles are aligned by simultaneously applying magnetic force to the elastic member while performing the bonding of the first member.
